# EUROPEAN PATENT APPLICATION

(11) **EP 4 823 258 A1**
(43) Date of publication of application: **14.10.2026**
(21) Application number: 25170997.8
(22) Date of filing: 16.04.2025
(51) Int. Cl.: H05K 7/20

(54) **POWER CONVERSION SYSTEM**

(30) Priority: 08.04.2025 CN 202510436898
(71) Applicant: Zhejiang Jinko Energy Storage Co., Ltd., Jiaxing, Zhejiang (CN)
(72) Inventor: XU, Guodong, Haining (CN); SUN, Xuebing, Haining (CN); YU, Jian, Haining (CN); CHENG, Min, Haining (CN); ZHANG, Luhua, Haining (CN)
(74) Representative: Balder IP Law, S.L.

(57) **Abstract**

The embodiments of the present disclosure relate to the technical field of energy storage, and a power conversion system is disclosed. The power conversion system includes a housing (11), a liquid cooling plate (12), and a circuit board assembly (13). The housing (11) defines a receiving chamber (101), and is provided with a first opening (102) and a second opening (103) both in fluid communication with the receiving chamber (101). The liquid cooling plate (12) is disposed in the receiving chamber (101) and is provided inside with a flow channel (121) for circulating coolant, as well as a first cooling room (122) and a second cooling room (123) formed on the flow channel (121). The liquid cooling plate (12) is in fluid communication with an inlet pipeline (124) and an outlet pipeline (125). One end of the inlet pipeline (124) is in fluid communication with a first end of the flow channel (121), and the other end of the inlet pipeline (124) extends out of the receiving chamber (101) through the first opening (102). One end of the outlet pipeline (125) is in fluid communication with a second end of the flow channel (121), and the other end of the outlet pipeline (125) extends out of the receiving chamber (101) through the second opening (103). The circuit board assembly (13) is connected to the liquid cooling plate (12) at one side of the liquid cooling plate (12), and includes a circuit board (131), a first heat-generating component (132) and a second heat-generating component (133) that are electrically connected to the circuit board (131). The power conversion system can facilitate the heat dissipation performance of the liquid cooling plate (12).

## Description

### TECHNICAL FIELD

Various embodiments of the present invention relate to the technical field of energy storage, and in particularly, to a power conversion system.

### BACKGROUND

With the advancement of renewable energy technologies, the application of energy storage devices has become increasingly widespread. Energy storage devices store electrical energy through battery modules formed by battery cells and output the stored electrical energy to external systems when needed. In addition to the battery modules, energy storage devices also include a battery management device, an energy management device, and a power conversion system, which cooperate with the battery modules. The power conversion system controls the charging and discharging of the battery modules and serves as a key component enabling the bidirectional flow of electrical energy between the energy storage device and a power grid.

The power conversion system includes numerous electronic components, some of which generate heat during operation, leading to an increase in the internal temperature of the power conversion system. Typically, the power conversion system is equipped with a liquid cooling plate for heat dissipation. The cooling performance of the liquid cooling plate directly affects the normal operation of the power conversion system. Therefore, ensuring the effective heat dissipation of the liquid cooling plate within the power conversion system is a crucial issue.

### SUMMARY

A power conversion system is provided according to embodiments of the present invention. The present invention is set out in the appended set of claims.

A power conversion system is provided according to an embodiment of the present invention. The power conversion system includes a housing, liquid cooling plate, and a circuit board assembly. The housing defines a receiving chamber, and is provided with a first opening and a second opening both in fluid communication with the receiving chamber. The liquid cooling plate is disposed in the receiving chamber and is provided internally with a flow channel for circulating coolant, as well as a first cooling room and a second cooling room formed on the flow channel. The liquid cooling plate is connected with an inlet pipeline and an outlet pipeline. One end of the inlet pipeline is in fluid communication with a first end of the flow channel, and the other end of the inlet pipeline extends out of the receiving chamber through the first opening. One end of the outlet pipeline is in fluid communication with a second end of the flow channel, and the other end of the outlet pipeline extends out of the receiving chamber through the second opening. The circuit board assembly is connected to the liquid cooling plate and disposed at one side of the liquid cooling plate, and includes a circuit board, a first heat-generating component and a second first heat-generating component that are electrically connected to the circuit board. The first heat-generating component is attached to the liquid cooling plate and faces the first cooling room, and the second first heat-generating component is attached to the liquid cooling plate and faces the second cooling room.

In some embodiments, the liquid cooling plate includes a bottom plate and a cover plate. The bottom plate has a flow channel section that is a depression from one side towards the other side to form the flow channel, a first section forming the first cooling room, and a second section forming the second cooling room. The cover plate is connected to the bottom plate and covers the flow channel section, the first section, and the second section. The first heat-generating component and the second heat-generating component are attached on the cover plate.

In some embodiments, the first section is greater than the second section in area.

In some embodiments, there are multiple first heat-generating components, which are attached to the liquid cooling plate in the same direction and face the same first cooling room. Multiple flow-diverting structures in one-to-one correspondence with the multiple first heat-generating components are provided in the first cooling room. The flow-diverting structures are configured to guide the coolant to flow along the arrangement direction of the multiple first heat-generating components.

In some embodiments, the multiple flow diverting structures include a plurality of ribs spaced apart from each other. Each of the plurality of ribs extends along a same direction as the first heat-generating components are arranged, and the plurality of ribs are arranged in a direction perpendicular to a direction in which the first heat-generating components are arranged.

In some embodiments, there are multiple second heat-generating components and multiple second cooling rooms, with the multiple second heat-generating components arranged in one-to-one correspondence with the multiple second cooling rooms.

In some embodiments, each second cooling space is provided with a plurality of turbulence columns, which are arranged in an array within the second cooling space.

In some embodiments, the second cooling rooms include a plurality of first compartments and a plurality of second compartments that are in one-to-one correspondence, and the first compartments each being spaced apart from and in fluid communication with the corresponding second compartment.

In some embodiments, at least some first compartments are in fluid communication with the first cooling space.

In some embodiments, the flow channel is provided with a partition. The partition extends in a same direction as the flow channel extends, and the partition is provided with a notch facing the first cooling room or the second cooling room.

In some embodiments, the housing includes a first inner wall surface facing one side surface of the liquid cooling plate and a second inner wall surface facing the other side surface of the liquid cooling plate. The liquid cooling plate is spaced apart from both the first and second inner wall surfaces, and the liquid cooling plate is provided with a through hole extending in a thickness direction of the liquid cooling plate.

In some embodiments, there are multiple through holes, and the multiple through holes are distributed between the first cooling room and the second cooling room.

In some embodiments, the flow channel includes an inlet flow channel, an outlet flow channel, and a series flow channel. One end of the inlet flow channel is in fluid communication with the inlet pipeline, and the other end of the inlet flow channel is in fluid communication with the first cooling room. One end of the outlet flow channel is in fluid communication with the outlet pipeline, and the other end of the outlet flow channel is in fluid communication with the second cooling room. The first cooling room is in fluid communication with the second cooling room through the series flow channel.

In some embodiments, the inlet flow channel and the outlet flow channel are located on opposite sides of the first cooling room or the second cooling room.

In some embodiments, the liquid cooling plate has a first edge and a second edge arranged opposite to each other, the first heat-generating components are arranged along the first edge, and the inlet and outlet pipelines are connected to the second edge.

In some embodiments, the power conversion system further includes a liquid detection assembly, which is positioned within the receiving chamber and is located near the inlet or outlet pipelines.

### BRIEF DESCRIPTION OF THE DRAWINGS

One or more embodiments are exemplarily described with reference to the figures in the drawings. These exemplary descriptions are not intended to limit the embodiments. Elements with the same reference numerals in the drawings represent similar elements, unless otherwise specifically stated. The figures in the drawings are not intended to impose proportional limitations.
FIG. 1 is a perspective view of a power conversion system according to some embodiments of the present invention;
FIG. 2 is a schematic diagram of an internal structure of a power conversion system according to some embodiments of the present invention;
FIG. 3 is a schematic diagram showing a partial assembly structure of a housing of a power conversion system according to some embodiments of the present invention;
FIG. 4 is a schematic diagram illustrating the configuration of a liquid cooling plate and heat-generating components in a power conversion system according to some embodiments of the present invention;
FIG. 5 is a perspective view of the liquid cooling plate in the power conversion system according to some embodiments of the present invention;
FIG. 6 is a perspective view of a bottom plate of a liquid cooling plate in a power conversion system according to some embodiments of the present invention;
FIG. 7 is a top view of a bottom plate of a liquid cooling plate in a power conversion system according to some embodiments of the present invention;
FIG. 8 is a perspective view of a bottom plate of a liquid cooling plate in a power conversion system from another view according to some embodiments of the present invention; and
FIG. 9 is a bottom view of a bottom plate of a liquid cooling plate in a power conversion system according to some embodiments of the present invention.

### DETAILED DESCRIPTION OF THE EMBODIMENTS

To make the objectives, technical solutions, and advantages of the embodiments of the present invention clearer, the following detailed description of the various embodiments will be made with reference to the drawings. However, those skilled in the art should understand that, in the various embodiments of the present invention, many technical details have been provided to help the reader better understand the invention. Nevertheless, the technical solutions protected by the present invention can be implemented even without these technical details and without the various modifications and variations based on the following embodiments. The division of the following embodiments is for descriptive convenience only and should not be construed as limiting the specific implementation of the invention. The various embodiments can be combined and referenced with each other, provided there are no contradictions.

Unless otherwise defined, all technical and scientific terms used herein have the same meaning as understood by those skilled in the art in the technical field to which the present invention pertains. The terms used in the present invention are intended for the purpose of describing specific embodiments and are not meant to limit the present invention. The terms "include" and "have" and any variations thereof, as used in the description, claims, and the drawings, are intended to cover non-exclusive inclusion.

In the description of the embodiments of the present invention, unless otherwise explicitly stated and defined, the technical terms such as "install," "coupled," and "connected" should be broadly understood. For example, they may refer to fixed connections, detachable connections, or integrated forms; they may refer to mechanical connections or electrical connections; they may be direct connections or indirect connections, or may refer to internal communication between two components or the interaction between two components. For those skilled in the art, the specific meaning of these terms in the embodiments of the present invention can be understood based on the context.

As the power generation from renewable sources increases, the importance of energy storage is also growing. Energy storage devices use battery cells as storage units to form electrochemical energy storage systems. The power conversion system (PCS) is the core component in energy storage devices, controlling charging and discharging through bidirectional AC-DC conversion.

With increases in the battery capacity of energy storage devices, the power of the power conversion system (PCS) is also growing. During operation, the electrical components inside the power conversion system generate significant heat, causing the internal temperature of the power conversion system to rise and affecting its normal functioning. The cooling approach currently used in power conversion system include air cooling and liquid cooling. Due to the relatively low heat exchange efficiency of air cooling, its cooling effect on internal electronic components is limited, making it less effective in controlling the temperature of components that generate significant heat. Liquid cooling, on the other hand, adopts a liquid cooling plate. The cooling medium circulates inside the liquid cooling plate, removing the heat generated by the electronic components during the operation of the power conversion system. The liquid cooling plate can effectively improve heat exchange efficiency. However, with numerous electronic components in the power conversion system, it is necessary to design a coordinated cooling approach between the electronic components and the liquid cooling plate to ensure effective heat dissipation for the various components.

A power conversion system is provided according to some embodiments of the present invention, to ensure the effective heat dissipation of the liquid cooling plate within the power conversion system. The liquid cooling plate in the power conversion system is designed with separate cooling rooms tailored to different electronic components. As the cooling medium circulates through the liquid cooling plate, it spreads across these distinct cooling rooms. Electronic components that generate higher heat are arranged in the areas corresponding to these rooms. The components are in direct contact with the surfaces of the cooling rooms, allowing the heat generated during operation to be efficiently transferred to the circulating cooling medium. This arrangement ensures that the circulating cooling medium efficiently dissipates heat from the various electronic components, maintaining optimal thermal performance for them.

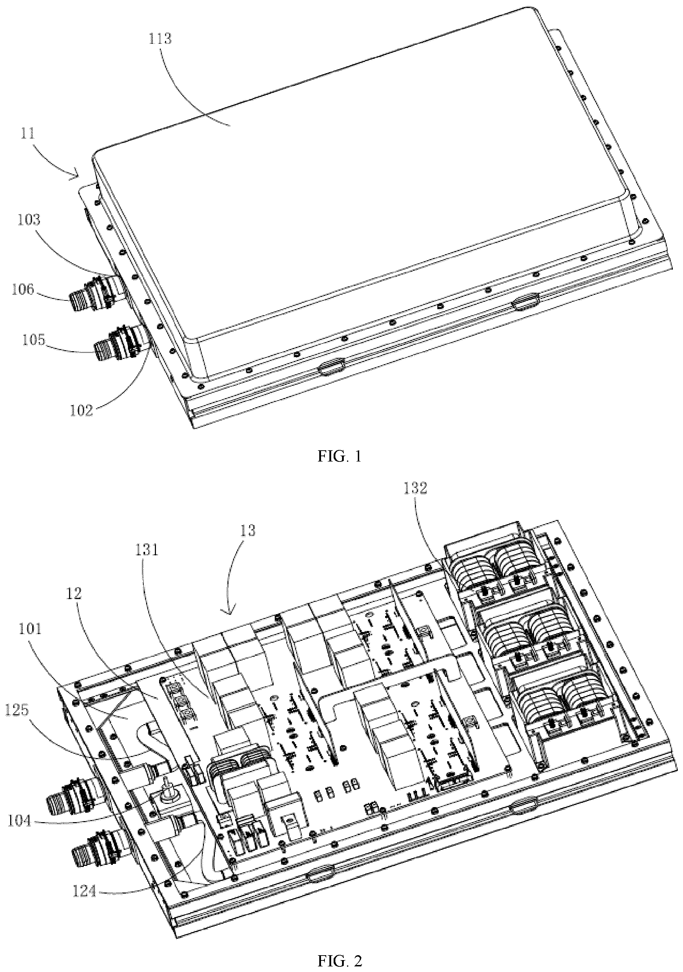

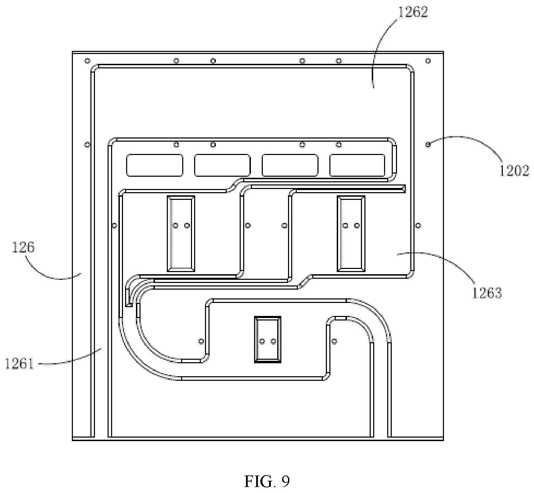

Below, the structure of the power conversion system according to some embodiments of the present invention will be described with reference to FIG. 1 to FIG. 9.

As shown in FIG. 1 to FIG. 9, the power conversion system according to some embodiments of the present invention includes a housing 11, a liquid cooling plate 12, and a circuit board assembly 13. The housing 11 defines a receiving chamber 101, a first opening 102 and a second opening 103 that are in fluid communication with the receiving chamber 101. The liquid cooling plate 12 is located within the receiving chamber 101 and includes a flow channel 121 through which the coolant flows, with a first cooling room 122 and a second cooling room 123 formed on the flow channel 121. The liquid cooling plate 12 is in fluid communication with an inlet pipeline 124 and an outlet pipeline 125. One end of the inlet pipeline 124 is in fluid communication with the first end 1211 of the flow channel 121, and the other end of the inlet pipeline 124 extends out of the receiving chamber 101 through the first opening 102. One end of the outlet pipeline 125 is in fluid communication with the second end 1212 of the flow channel 121, and the other end of the outlet pipeline 125 extends out of the receiving chamber 101 through the second opening 103. The circuit board assembly 13 is connected to the liquid cooling plate 12 and positioned on one side of the liquid cooling plate 12. The circuit board assembly 13 includes a circuit board 131, and a first heat-generating component 132 and a second heat-generating component 133 that are electrically connected to the circuit board 131. The first heat-generating component 132 is attached to the liquid cooling plate 12 and faces the first cooling room 122. The second heat-generating component 133 is attached to the liquid cooling plate 12 and faces the second cooling room 123.

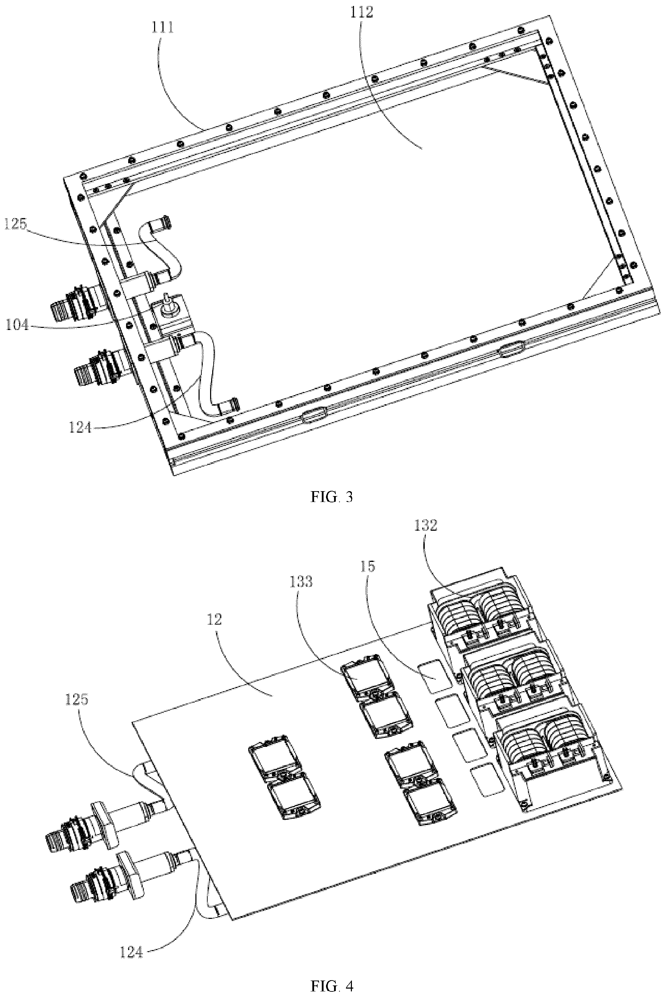

The housing 11 forms the external casing of the power conversion system, providing protection for the circuit board assembly 13 inside the power conversion system. The housing 11 defines the receiving chamber 101 inside, which provides space for the circuit board assembly 13 that plays a controlling role. The first opening 102 and the second opening 103 of the housing 11 provide installation passages for the entry and exit of the coolant. Additionally, the housing 11 may have electrical interfaces for connecting the power conversion system to the circuit of the energy storage device. The housing 11 can adopt a split structure including a bottom shell and a top cover, where the bottom shell forms an inner cavity, and the top cover seals the opening at the top of the bottom shell. Alternatively, the housing 11 can use a spliced enclosed structure, as shown in FIG. 3, where multiple strip components 111 are connected end to end to form the sidewalls of the housing 11, and are spliced on both sides with the bottom shell 112 and the top cover 113.

The liquid cooling plate 12 serves the purpose of heat dissipation in the power conversion system. The liquid cooling plate 12 may be arranged inside the receiving chamber 101 of the housing 11. The liquid cooling plate 12 defines multiple mounting holes, allowing it to be fixed to the sidewall of the housing 11 by fasteners. The liquid cooling plate 12 includes a mounted side and a non-mounted side, which are opposite to each other. The mounted side has a flat surface on which various electronic components can be mounted. The liquid cooling plate 12 is provided with mounting holes 1201, where the electronic components can be fixed at the respective positions by fasteners. The non-mounted side of the liquid cooling plate 12 faces the bottom of the housing 11 and no electronic component is mounted on the non-mounted side. Concentrating a large number of electronic components on one side of the liquid cooling plate 12 can ensure the integration of the components, which is conducive to the miniaturization of the power conversion system.

The liquid cooling plate 12 has a complete flow channel 121, and different cooling rooms are formed on the flow channel 121. The cooling rooms face the areas where electronic components are mounted on the surface of the liquid cooling plate 12. These cooling room can be configured in regular shapes such as rectangular, cylindrical, or prismatic, or can be configured in irregular shapes. The projection area of the cooling rooms on the surface of the liquid cooling plate 12 may either match or exceed the projection area of the heat-generating components attached to the surface of the liquid cooling plate 12. For example, the first cooling space 122, disposed corresponding to the inductor, may have a projection area on the liquid cooling plate 12 that exceeds the projection area of the inductor. The second cooling space 123, disposed corresponding to the insulated-gate bipolar transistor (IGBT) power module, can ensure that its projection area on the liquid cooling plate 12 is larger than the projection area of the IGBT power module.

After entering the flow channel 121, the coolant can flow through the various cooling rooms within the liquid cooling plate 12, removing the heat generated by the electronic components during operation, and then flows out of the housing 11 through the complete flow path. The complete flow path includes the inlet pipeline 124 and the outlet pipeline 125. The inlet pipeline 124 introduces the coolant from exterior into the interior of the housing 11. One end of the inlet pipeline 124 is in fluid communication with the first end 1211 of the flow channel 121, which is the end where the coolant enters the liquid cooling plate 12. The other end of the inlet pipeline 124 passes through the first opening 102 and extends outside the receiving chamber 101, forming the coolant inlet channel. The outlet pipeline 125 directs the circulating coolant in the liquid cooling plate 12 out of the housing 11. One end of the outlet pipeline 125 is in fluid communication with the second end 1212 of the flow channel 121, which is the end where the coolant exits the liquid cooling plate 12. The other end of the outlet pipeline 125 passes through the second opening 103 and extends outside the receiving chamber 101, forming the coolant outlet channel. The coolant may be water, deionized water, propylene glycol aqueous solution, ethylene glycol aqueous solution, or other suitable liquids.

The circuit board assembly 13 is the part inside the power conversion system responsible for controlling charging and discharging. The circuit board 131 in the circuit board assembly 13 serves control functions. The circuit board 131 is equipped with electronic components such as IGBT power modules, capacitors, inductors, and other components. The circuit board assembly 13 is connected to the mounted side of the liquid cooling plate 12, with the electronic components that generate significant heat being mounted on the mounted side of the liquid cooling plate 12. The first heat-generating component 132 and the second heat-generating component 133 are the electronic components in the circuit board assembly 13 that produce the most heat. These heat-generating components that produce the most heat include inductors and IGBT power modules. The inductors and IGBT power modules are arranged in the regions of the liquid cooling plate 12 that face the cooling rooms. The first heat-generating component 132 and the second heat-generating component 133 may be the same or different electronic components. In practice, depending on the positioning of the IGBT power modules and inductors, the liquid cooling plate 12 is designed with sufficiently large cooling rooms to accommodate coolant under the heat sources mounted on its surface. For example, each IGBT power module and inductor has a cooling room defined by a convex shell, ensuring that sufficient coolant flows beneath it.

The power conversion system provided in some embodiments of the present invention adopts a liquid cooling plate 12 to perform liquid cooling on the circuit board assembly 13 inside the housing 11. The liquid cooling plate 12 includes a flow channel 121 and cooling rooms customized to electronic components. As the coolant circulates through the flow channel 121, it passes through the various cooling rooms, thereby removing heat from the different electronic components and transferring the heat to the surface of the liquid cooling plate 12 from the entire circuit board assembly 13. Forming cooling rooms in different areas within the liquid cooling plate 12 can provide a broad space for the coolant to flow and diffuse, effectively removing the heat from electronic components that generate more heat, which is then transferred to the surface of the liquid cooling plate 12. This ensures the effective heat dissipation of the liquid cooling plate 12 within the power conversion system.

In some embodiments, the liquid cooling plate 12 includes a bottom plate 126 and a cover plate 127. The bottom plate 126 includes a flow channel section 1261, which is recessed from one side toward the other side to form the flow channel 121, a first section 1262 that forms the first cooling room 122, and a second section 1263 that forms the second cooling room 123. The cover plate 127 is connected to the bottom plate 126 and covers the flow channel section 1261, the first section 1262, and the second section 1263. The first heat-generating component 132 and the second heat-generating component 133 are attached to the cover plate 127.

In other words, the liquid cooling plate 12 adopts a spilt structure. The bottom plate 126 is located on the bottom side of the liquid cooling plate 12, while the cover plate 127 is located on the top side of the liquid cooling plate 12. The flow channel 121 and the cooling rooms located on the flow channel 121 are formed on the bottom plate 126. The bottom plate 126 is designed with a recess that creates the flow channel 121 for coolant circulation and cooling rooms that can be either the same size or different sizes. The cover plate 127 is attached to the bottom plate 126, sealing the flow channel 121 and the cooling rooms on the flow channel 121. This forms the flow channel 121 and cooling rooms, which are isolated from the outside.

The liquid cooling plate 12, adopting the combined structure of the bottom plate 126 and the cover plate 127, can have a simple structure, making it easier to manufacture. In practice, both the bottom plate 126 and the cover plate 127 can be made from sheet metal components with regular shapes, such as square, rectangular, or circular, or can be made from irregular-shaped sheet metal. The recess on the bottom plate 126 can be formed by stamping processes. The bottom plate 126 and the cover plate 127 are combined through welding to ensure the sealing of the flow channel 121 and the cooling rooms. To facilitate the installation of the liquid cooling plate 12, at least part of the edge around the bottom plate 126 can have a folded edge 1264, which can be overlapped with the sidewall of the housing 11. In addition, the liquid cooling plate 12 is fixed inside the housing 11 by fasteners. The heat-generating components are fixed to the cover plate 127 by fasteners, and the circuit board 131 is fixed to the cover plate 127 by fasteners, leaving a gap between the circuit board 131 and the surface of the cover plate 127 to provide space for the first heat-generating component 132 and the second heat-generating component 133.

Additionally, the first section 1262 can be larger than the second section 1263 on the bottom plate 126 in area.

The sections with different areas are designed to form cooling rooms, which can accommodate different electronic components. The first section 1262 is the location where the first cooling room 122 is formed, designed for the heat dissipation of larger inductors. The second section 1263 is the location where the second cooling room 123 is formed, designed for the heat dissipation of smaller IGBT power modules. The area of the first section 1262 is larger than that of the second section 1263, a larger convex shell can be formed on the side of the bottom plate 126 that is farther from the cover plate 127, thus increasing the structural strength of the first cooling room 122 to better accommodate the inductors.

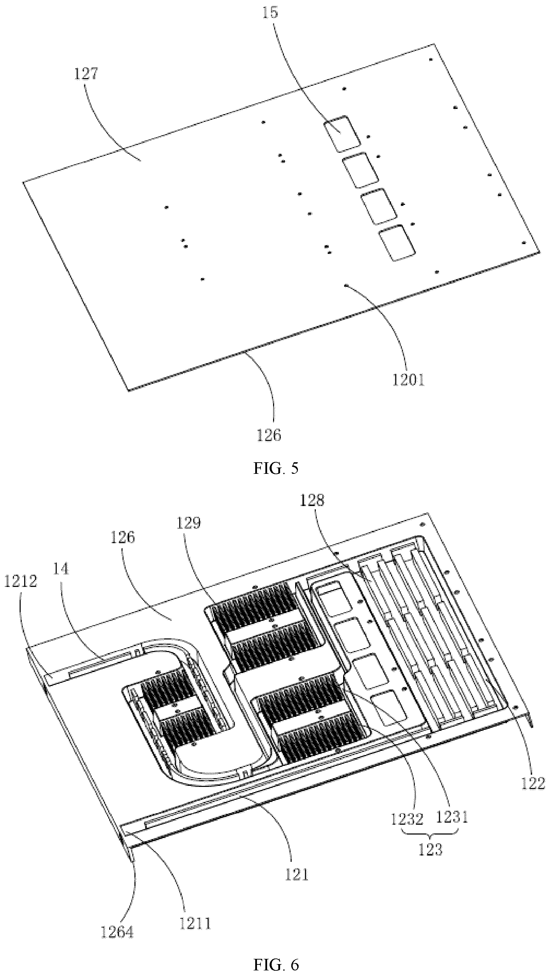

As shown in FIG. 4 and FIG. 6, multiple first heat-generating components 132 are provided, and arranged along the same direction on the liquid cooling plate 12, facing the same first cooling room 122. Within the first cooling room 122, multiple flow-diverting structures 128 are provided, in one-to-one correspondence with the multiple first heat-generating components 132. The flow-diverting structures 128 direct the coolant to flow along the arrangement direction of the multiple first heat-generating components 132. In this way, effective heat dissipation for the larger-sized first heat-generating components can be ensured.

The first heat-generating component 132, which is a larger component with a relatively lower heat output compared to the second heat-generating component 133, can be arranged such that the multiple first heat-generating components 132 face the same first cooling room 122. This arrangement reduces barriers in the flow path for the coolant within the liquid cooling plate 12, allowing the coolant to pass over the multiple first heat-generating components 132 quickly and at a constant speed. In the process of dissipating heat from the multiple first heat-generating components 132, the flow of the coolant is not subjected to significant resistance.

Moreover, the first cooling room 122 is provided with flow-diverting structures 128 for the first heat-generating components 132, respectively. The flow-diverting structure 128 is located facing the corresponding first heat-generating component 132. The flow-diverting structures 128 guide the flow of the coolant, allowing it to move along the arrangement direction of the multiple first heat-generating components 132. As a result, the coolant entering the first cooling room 122 can sequentially pass over the first heat-generating components 132, ensuring a smoother flow within the first cooling room 122.

The flow-diverting structures 128 may be formed as columnar structures distributed in a dot-like pattern, as protrusions extending in a straight line, or as continuously distributed droplet-shaped structures. The flow-diverting structures 128 can be fixed within the cooling room or movably arranged within the cooling room to adjust the flow diversion. Additionally, the flow-diverting structures 128 may be designed with a uniform size to achieve a constant flow speed or with varying sizes to modify the flow speed.

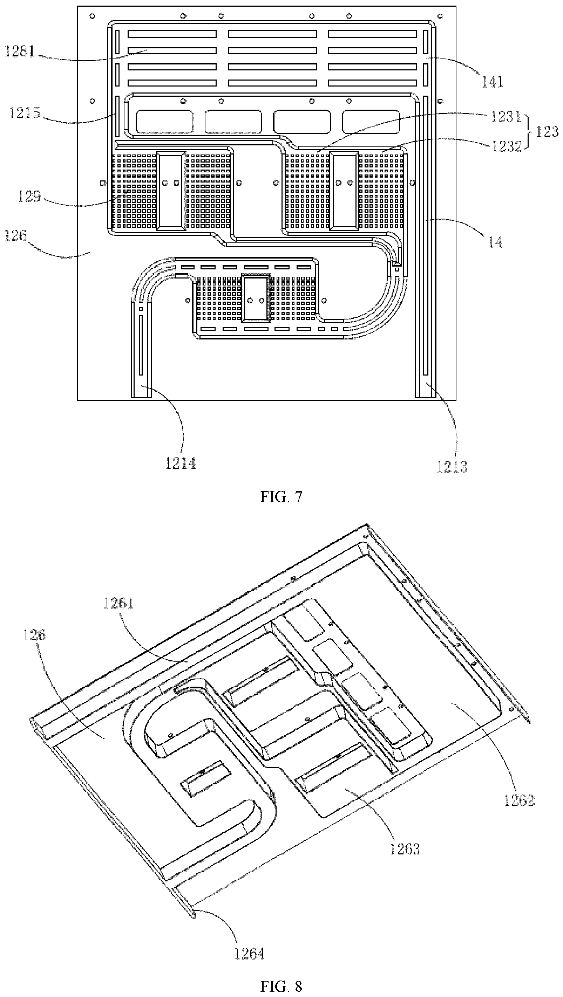

The first cooling room 122 may be integrated into the flow channel 121 in a series configuration. Specifically, the first cooling room 122 may be in fluid communication with different sections of the flow channel 121 in various ways. Since the first cooling room 122 occupies a large area within the liquid cooling plate 12, one or more inlets may be provided for coolant entry, and one or more outlets for coolant discharge. That is, the flow channel 121 may include a main flow channel 121 supplying coolant to the first cooling room 122, or multiple branch flow channels 121 supplying coolant to the first cooling room 122 simultaneously. Likewise, the flow channel 121 may include a main flow channel 121 discharging the coolant from the first cooling room 122, or multiple branch flow channels 121 discharging the coolant from the first cooling room 122 simultaneously. FIG. 6 and FIG. 7 illustrate a configuration where the coolant enters from one side of the first cooling room 122 and exits from the opposite side through the flow channel 121. In practice, the coolant can enter from all around the first cooling room 122 and exit from the center bottom of the first cooling room 122.

In some embodiments, the flow-diverting structure 128 may include multiple ribs 1281 arranged at intervals. Each rib 1281 extends along the arrangement direction of the multiple first heat-generating components 132, while the arrangement direction of the multiple ribs 1281 is perpendicular to the arrangement direction of the multiple first heat-generating components 132. In this way, the rib-shaped flow-diverting structure can guide the coolant flow while enhancing the structural strength of the first cooling room.

The multiple ribs 1281 protrude within the first cooling room 122, and guide the coolant entering the first cooling room 122 along different flow paths. The ribs 1281 extend along the arrangement direction of the multiple first heat-generating components 132, allowing the coolant to flow over the first heat-generating components 132 along the extension direction of the ribs 1281. Further, the arrangement direction of the multiple ribs 1281 is perpendicular to the arrangement direction of the multiple first heating elements 132, enabling the coolant to flow into multiple flow paths after entering the first cooling room 122. The coolant in different flow paths can effectively dissipate heat from the first heat-generating components 132.

In practice, the ribs 1281 may have a uniform thickness or varying thickness along their extension direction. That is, the ribs 1281 may be shaped so that one end is wider or narrower than the other, or they may be shaped so that both ends are wider or narrower compared to the middle. Additionally, the ribs 1281 each may be configured as a regular shape such as a square, a rectangular, or a trapezoidal, or as an irregular shape, in cross section.

As shown in FIG. 4 and FIG. 6, multiple second heat-generating components 133 and multiple second cooling rooms 123 are provided. The multiple second heat-generating components 133 are arranged within the multiple second cooling rooms 123 in one-to-one correspondence. In this way, the inclusion of the turbulence columns can enhance the heat dissipation performance for the second heat-generating components.

In other words, each of the second heat-generating components 133 can be arranged within respective second cooling room 123. Arranging the second heat-generating components 133 within separate second cooling rooms 123 can have sufficient and effective heat dissipation, accommodating the heat dissipation needs of the second heat-generating components 133 that generate heat more significantly. The multiple second cooling rooms 123 can be distributed in regions of the same size or varying sizes.

The second cooling rooms 123 can be arranged in series within the flow channel 121. Specifically, the second cooling rooms 123 can be in fluid communication with different sections of the flow channel 121 in various configurations. Since the second cooling rooms 123 occupies a large area within the liquid cooling plate 12, one or more inlets can be provided for the coolant to enter the second cooling rooms 123, and one or more outlets can be provided for the coolant to exit. That is, the flow channel 121 may have a main flow channel 121 to supply coolant to the second cooling rooms 123, or multiple branch flow channels 121 can simultaneously supply coolant to the second cooling rooms 123. Likewise, the flow channel 121 may have a main flow channel 121 to discharge the coolant from the second cooling rooms 123, or multiple branch flow channels 121 to simultaneously discharge the coolant. FIG. 6 and FIG. 7 show the flow channel 121 where the coolant enters from one side of the second cooling rooms 123 and exits from the opposite side. In practice, the coolant can also enter from all around the second cooling room 123 and exit from the central bottom of the second cooling room 123.

Additionally, the second cooling rooms 123 and the first cooling rooms 122 may be arranged on the same plane, with the same depth. Alternatively, the second cooling rooms 123 and the first cooling rooms 122 may be arranged on different planes, with different depths. For example, the second cooling rooms 123 may have a height difference relative to the first cooling rooms 122, being partially or fully staggered from the first cooling rooms 122 in the thickness direction of the liquid cooling plate 12. The height difference between the cooling rooms can accelerate the flow of the coolant with the help of gravity, thereby enhancing the heat dissipation performance.

As shown in FIG. 6 and FIG. 7, each second cooling room 123 may be provided with multiple turbulence columns 129, which are arranged in an array within the second cooling room 123.

The turbulence columns 129 can control the flow speed of the coolant within the second cooling room 123, allowing the coolant to be in full contact with the inner wall of the second cooling room 123 in the liquid cooling plate 12. The heat conducted from the second heat-generating components 133 to the liquid cooling plate 12 can be carried away by the coolant entering the second cooling room 123. The number of turbulence columns 129 may be set between ten and twenty, arranged in an array within the second cooling room 123. After entering the second cooling room 123, the coolant flows between the turbulence columns 129, undergoing turbulence effects that control the flow speed, ensuring effective heat dissipation for the second heat-generating components 133. In practice, the turbulence columns 129 may be configured in regular shapes such as cylindrical, prismatic, or pyramidal, or in irregular shapes.

Arranging the turbulence columns 129 within the cooling room can effectively improve the heat dissipation performance. The turbulence columns 129 can split the coolant, creating localized accelerated flow within the cooling room, which induces turbulence. This allows the heat conducted to the surface of the liquid cooling plate 12 to be quickly transferred to the coolant within the cooling room, thus enhancing the heat exchange. Additionally, the turbulence columns 129 can increase the contact surface with the coolant, further improving the heat exchange performance.

In some embodiments, the multiple second cooling rooms 123 may be divided into multiple first compartments 1231 and multiple second compartments 1232, where the first compartments 1231 and the second compartments 1232 are in one-to-one correspondence. Each first compartment 1231 is spaced apart from and is in fluid communication with its corresponding second compartment 1232. In this way, the flow channel can be simplified and the length of the flow path can be reduced.

The first compartments 1231 and the second compartments 1232 are assigned to second heat-generating components 133 respectively. The first compartment 1231 is in fluid communication with its corresponding second compartment 1232 and they may be arranged in parallel along the entire flow path, which can simplify the flow path length in case of large number of second heat-generating components 133. Such pair of compartments can receive the coolant simultaneously under the diversion of the flow channel 121, and direct the coolant to flow towards the downstream of the flow path.

Additionally, at least some of the first compartments 1231 are in fluid communication with the first cooling room 122. In this way, these first compartments are parallel in the flow channel.

At least some of the first compartments 1231 are in fluid communication with the first cooling room 122, allowing two or more first compartments 1231 to simultaneously receive the coolant flowing out of the first cooling room 122. In other words, some of the first compartments 1231 can be arranged in parallel along the flow path. This enables the coolant to be diverted to different sections of the second cooling room 123, reducing the flow path for the coolant and ensuring effective heat dissipation for the second heat-generating components 133 located near the coolant outlet. In practice, parallel connection can also be made only between the first compartment 1231 and its corresponding second compartment 1232, while the multiple first compartments 1231 are arranged in series along the flow path.

As shown in FIG. 4, there are six second heat-generating components, each corresponding to a second cooling room 123, making a total of six second cooling rooms. These six second cooling rooms 123 can be divided into three groups, with each group including a first compartment 1231 and a second compartment 1232. Two of the three groups are arranged in the central region of the liquid cooling plate 12, while the third group is placed in a region distant from the first cooling room 122. The two groups of second cooling rooms 123 in the central region of the liquid cooling plate 12 are arranged in parallel along the coolant flow path. The third group of second cooling rooms 123 is arranged in series along the coolant flow path and is in fluid communication with the previous two groups. The arrangement shown in FIG. 6 simplifies the structure of the flow channel 121, allowing the coolant to flow separately. After entering the different second cooling rooms 123, the coolant effectively dissipates heat from the second heat-generating components 133, ensuring the overall flow rate of the coolant.

In some embodiments, a partition 14 can be provided within the flow channel 121. The partition 14 extends in a same direction as the flow channel 121. The partition 14 is provided with a notch 141 facing the first cooling room 122 or the second cooling room 123.

The partition 14 can divide the coolant within the flow channel 121, allowing the coolant to flow along both sides of the partition 14. Reducing the cross-section of the flow channel 121 helps to increase the flow speed of the coolant. At the locations corresponding to different cooling rooms, the partition 14 is provided with notches 141, creating a reserved gap that allows the coolant to flow towards the cooling room. This ensures that the coolant flowing on the side of the partition 14, away from the cooling room, can enter the cooling room. Additionally, the position and size of the notch 141 depend on the flow diversion requirements of the coolant.

Additionally, the partition 14 can expand the welding surface between the cover plate 127 and the bottom plate 126, enhancing the overall structural strength of the liquid cooling plate 12. The bottom plate 126 may include screw hole posts 1202, which can be formed simultaneously with the cooling rooms through stamping. These screw hole posts 1202 are designed to accommodate screw holes, providing a foundation for fastener connections.

In some embodiments, the housing 11 includes a first inner surface facing one side of the liquid cooling plate 12 and a second inner surface facing the opposite side of the liquid cooling plate 12. The liquid cooling plate 12 is spaced apart from both the first and second inner surfaces. The liquid cooling plate 12 is provided with through holes 15 that extend through the thickness direction of the liquid cooling plate 12.

In other words, a gap exists between the liquid cooling plate 12 and the inner surface of the housing 11 in the thickness direction, thus forming a space on both sides of the liquid cooling plate 12. The space on the mounted side of the liquid cooling plate 12 can house the circuit board assembly 13, with the circuit board 131 being fixed to the liquid cooling plate 12 by fasteners such as screws. The space on the non-mounted side of the liquid cooling plate 12 forms a reserved space. During the circulation of coolant within the liquid cooling plate 12, no electronic components are in operation on the non-mounted side, resulting in lower temperatures. A lower-temperature reserved compartment can be formed on the non-mounted side of the liquid cooling plate 12, while an electrical compartment is formed on the mounted side. The through holes 15 can provide a passage for air convection between the two sides of the liquid cooling plate 12. Air convection can also help reduce the temperature at the circuit board assembly 13, aiding in heat dissipation. The through holes 15 can be designed in a regular shape such as square, rectangular, circular, or can be designed in an irregular shape.

As shown in FIG. 5, there may be multiple through holes 15, distributed between the first cooling room 122 and the second cooling room 123. This can enhance the air convection by increasing the number of through holes.

Increasing the number of through holes 15 can ensure effective air convection on both sides of the liquid cooling plate 12, thereby improving the heat dissipation. Multiple through holes 15 may be arranged in the same direction to simplify the manufacturing process. Concentrating multiple through holes 15 in the reserved space between different cooling rooms can prevent the impact of the through holes 15 on manufacturing the cooling rooms.

In some embodiments, the flow channel 121 may include an inlet flow channel 1213, an outlet flow channel 1214, and a series flow channel 1215. One end of the inlet flow channel 1213 is in fluid communication with the inlet pipeline 124, and the other end of the inlet flow channel 1213 is in fluid communication with the first cooling room 122. One end of the outlet flow channel 1214 is in fluid communication with the outlet pipeline 125, and the other end of the outlet flow channel 1214 is in fluid communication with the second cooling room 123. The first cooling room 122 is in fluid communication with the second cooling room 123 through the series flow channel 1215.

Different flow channels 121 serve different purposes. The inlet flow channel 1213 serves as the entry for the coolant, allowing the coolant to flow from the inlet pipeline 124 into the cooling rooms. The outlet flow channel 1214 serves as the exit for the coolant, allowing the coolant to flow from the cooling rooms into the outlet pipeline 125. The series flow channel 1215 communicates different cooling rooms in series, allowing the coolant to sequentially pass through the cooling rooms. This forms a complete flow channel within the liquid cooling plate 12, simplifying the flow path for the coolant. In this way, different flow channels form a complete flow path within the liquid cooling plate, ensuring the integrity of the flow path for the coolant.

In practice, the inlet flow channel 1213 and the outlet flow channel 1214 may be located on opposite sides of the first cooling room 122 or the second cooling room 123. In this way, separately placing the inlet and outlet flow channels on opposite sides of the cooling room, can reduce the influence between the inlet and outlet ends and also minimize space occupancy.

In other words, the entry and exit of the flow channel 121 are arranged on opposite sides of the cooling rooms, which can reduce the interaction between the coolant flowing through the inlet flow channel 1213 and the coolant flowing through the outlet flow channel 1214.

Additionally, the liquid cooling plate 12 may include a first edge and a second edge that are opposite to each other. The multiple first heat-generating components 132 are arranged along the first edge, and the inlet pipeline 124 and the outlet pipeline 125 are connected to the second edge.

The liquid cooling plate 12 can accommodate different components near its edge. The relatively large first heat-generating components 132 can be arranged along the first edge. That is, the first cooling room 122, which occupies a larger area, can be positioned near the edge to optimize space utilization within the liquid cooling plate 12. In addition, the inlet pipeline 124 and the outlet pipeline 125 are connected to the second edge, allowing for a centralized arrangement of the pipelines. This design enhances component integration and facilitates the connection of various parts.

In some embodiments, the power conversion system also includes a liquid detection assembly 104, which is positioned within the receiving chamber 101 and adjacent to the inlet pipeline 124 or the outlet pipeline 125. In this way, the liquid detection component can detect any coolant leakage within the receiving chamber.

Positioning the liquid detection assembly 104 at the inlet or the outlet on the liquid cooling plate 12 allows for effective monitoring of potential leakage. This enables timely detection of leakage, ensuring prompt intervention to protect the electronic components within the housing 11.

In practice, the liquid cooling plate is a key component in the cooling system of liquid-cooled PCS, accounting for 85% to 90% of the cooling system's cost. Improving the design and manufacturing process of the liquid cooling plate can reduce the cost of the cooling system of the liquid-cooled PCS. At present the liquid cooling plate is manufactured by separately machining the cover and bottom plates of the cooling plate through CNC (Computer Numerical Control) processing and then welding them together. The cover plate, the bottom plate, internal flow channels, and cooling fins are all formed through CNC milling of aluminum ingots, which results in material waste, high labor costs, and low production efficiency, leading to a high overall cost of the liquid cooling plate. To address the high cost of liquid cooling plate in existing liquid-cooled PCS, some embodiments of the present invention propose manufacturing the liquid cooling plate through stamping and welding on sheet metal. This approach offers several advantages. For instance, stamped components have uniform wall thickness, are lighter than milled aluminum ingots, and processing efficiency is improved by 95% compared to aluminum ingot milling. Additionally, the stamped liquid cooling plate can provide a larger gas-liquid heat exchange surface, resulting in enhanced heat dissipation performance, surpassing the cooling efficiency of traditionally milled aluminum cooling plates.

Specifically, the cover plate of the liquid cooling plate can be made from a flat aluminum sheet with a length of 629.8 mm, a width of 629.5 mm, and a thickness of 2 mm. The cover plate mainly supports the power board such as a circuit board and inductors. Since IGBTs and inductors require a high degree of flatness for installation, the cover plate is formed by stamping a 2 mm thick aluminum sheet. The holes on the upper half of the cover plate correspond to the mounting holes for the inductors, while the holes in the lower half of the cover plate correspond to the mounting holes for the IGBTs. As shown in FIG. 4, three inductors are mounted on the upper half of the liquid cooling plate, and six IGBTs are mounted on the lower half of the liquid cooling plate. The bottom plate of the liquid cooling plate is made from a stamped aluminum sheet with a length of 629.75 mm, a width of 629.5 mm, and a thickness of 26 mm. The inlet and outlet nozzles are welded onto the lower base plate of the liquid cooling plate.

Since the cover plate of the liquid cooling plate requires a high degree of flatness, it can be formed either by direct stamping or laser punching from an aluminum sheet. The lower base plate of the liquid cooling plate, which primarily accommodates the flow channels for the coolant, can be formed directly by stamping an aluminum sheet. The flow channels may be stamped into V-shaped grooves or semicircular grooves. To facilitate demolding, the draft angle of the stamped V-shaped grooves on the lower base plate may be designed to be greater than 5°. Based on actual flow requirements and structural constraints, the draft angle of the V-shaped grooves on the lower base plate may be set to 10°, with a depth of 26 mm in the vertical direction of the flow channel. Based on the cooling requirements of the PCS regarding the coolant flow rate and the consistency with the system interface, the inlet nozzle 105 and the outlet nozzle 106 may be selected as standard water nozzles with an outer diameter of 22 mm and an inner diameter of 14 mm. This selection helps reduce material waste, improve production efficiency, and lower processing costs. Additionally, it can reduce the weight of the liquid cooling plate, thereby cutting transportation costs. Furthermore, increasing the heat dissipation surface on the exterior of the liquid cooling plate enhances cooling performance.

Welding is the most critical process in the entire manufacturing of the liquid cooling plate. Poor welding is prone to leakage, resulting in a reduced product lifespan or even scrapping. The welding process is crucial for the reliability and safety of the liquid cooling plate. Therefore, the coolant flow channels inside the liquid cooling plate are designed in series, with the cross-sections of the channels kept as simple as possible, avoiding any abrupt changes in area.

The electrical components are installed on the upper side of the liquid cooling channels, referred to as the electrical compartment. All electrical components are mounted on the surface of the top cover of the liquid cooling plate. Since heat-generating components have high cooling requirements, they are placed in close contact with the surface of the liquid cooling plate. The top cover of the liquid cooling plate needs to ensure a certain level of flatness. As stamping is prone to deformation, which affects the flatness, the sheet metal stamping can be carried out only on the bottom plate of the liquid cooling plate.

The lower side of the flow channel, where no heat-generating components are arranged, is referred to as the liquid cooling compartment. This section can be designed with a leakage detection assembly and a drainage port. The leakage detection assembly may be designed as point-type liquid leak sensors or ribbon-type liquid leak sensors, which may utilize electrical principles such as resistance or capacitance to achieve leakage detection, or employ optical principles for leakage detection. The leakage detection assembly is placed outside the flow channel, within the liquid cooling compartment, and is connected to a control circuit in the electrical compartment via a communication line. The drainage port is located near the inlet and the outlet of the flow channel on the bottom plate. Under normal conditions, the drainage port is secured with bolts. When the leakage detection assembly sends an alarm, the bolts are loosened, allowing the liquid to be drained.

The liquid cooling plate is designed with different cooling rooms to meet the heat dissipation needs in various regions. The cooling regions of the liquid cooling plate include the inductor region and the IGBT power module region. The IGBT power modules generate heat quickly and concentratedly, requiring strict control of the coolant flow rate and speed passing through the six IGBT power modules. Since the IGBT power modules have high uniformity requirements on temperature, turbulence columns are added beneath the cooling modules for the IGBT power modules to control the flow rate and speed in this area. This ensures that the coolant flowing under the six IGBT power modules has a similar volume, a high flow rate, and a low speed, achieving effective and uniform heat dissipation across the cooling plate.

The three inductors generate a significant amount of heat, but their large heat dissipation area prevents rapid temperature rise, hence the uniformity requirements are not as high. The main concern is how to quickly carry away the heat emitted by the inductors to avoid excessive heat accumulation, which could affect the performance of surrounding electrical components. Therefore, a flow guide channel is reserved on the bottom plate beneath the inductors inside the liquid cooling plate to facilitate the rapid flow of coolant through this area. Additionally, to efficiently carry away the heat from the inductors, the protrusion of the bottom plate beneath the inductors is made sufficiently large to accommodate enough coolant. This ensures that the coolant below the inductors has a large flow rate and a high speed, effectively dissipating heat.

During the operation of the liquid cooling plate, the coolant flow rate and speed can be dynamically adjusted. Specifically, the coolant flow rate and speed can be adjusted based on the temperature rise of the IGBT power modules and the inductors. In the initial stage of the PCS startup, ambient temperature in the electrical compartment is relatively low, the coolant flow rate and speed are also low, or even zero. Once the PCS reaches a stable operating condition, typically when the temperature in the detection area reaches 50 to 55°C, the coolant flow rate and speed in the flow channel reach their rated values. When the temperature in the detection area exceeds 65°C, the flow rate and speed of the coolant are increased by 1.1 times the rated value to provide excessive cooling. If the temperature in the detection area exceeds 75°C, a warning may be triggered, and the system begins to derate. The generated heat decreases until the temperature returns to the range from 50 to 55°C.

It should be understood by those skilled in the art that the above embodiments are specific implementations of the present invention. In practice, various changes can be made in form and detail without departing from the scope of the present invention.

## Claims

1. A power conversion system, comprising:
a housing (11), which defines a receiving chamber (101), a first opening (102) and a second opening (103) that are in fluid communication with the receiving chamber (101);
a liquid cooling plate (12), arranged within the receiving chamber (101), the liquid cooling plate (12) having a flow channel (121) for coolant to circulate, and a first cooling room (122) and a second cooling room (123) formed on the flow channel (121), the liquid cooling plate (12) being in fluid communication with an inlet pipeline (124) and an outlet pipeline (125), one end of the inlet pipeline (124) being in fluid communication with a first end of the flow channel (121), the other end of the inlet pipeline (124) extends out of the receiving chamber (101) through the first opening (102), one end of the outlet pipeline (125) being in fluid communication with a second end of the flow channel (121), and the other end of the outlet pipeline (125) extends out of the receiving chamber (101) through the second opening (103); and
a circuit board assembly (13), arranged at one side of the liquid cooling plate (12) and connected to the liquid cooling plate (12), the circuit board assembly (13) including a circuit board (131), a first heat-generating component (132) and a second heat-generating component (133) that are electrically connected to the circuit board (131), the first heat-generating component (132) being attached on the liquid cooling plate (12) and facing the first cooling room (122), and the second heat-generating component (133) being attached on the liquid cooling plate (12) and facing the second cooling room (123).

2. The power conversion system according to claim 1, wherein the liquid cooling plate (12) includes a bottom plate (126) and a cover plate (127), the bottom plate (126) having a flow channel section (1261) that is a depression from one side towards the other side to form the flow channel (121), a first section (1262) forming the first cooling room (122), and a second section (1263) forming the second cooling room (123), the cover plate (127) being connected to the bottom plate (126) and covering the flow channel section (1261), the first section (1262), and the second section (1263), and the first heat-generating component (132) and the second heat-generating component (133) being attached on the cover plate (127).

3. The power conversion system according to claim 2, wherein the first section (1262) is greater than the second section (1263) in area.

4. The power conversion system according to claim 1, wherein a plurality of first heat-generating components (132) are provided, and the plurality of first heat-generating components (132) being attached on the liquid cooling plate (12) in a same direction and facing a same first cooling room (122), and the first cooling room (122) being provided with a plurality of flow-diverting structures (128) in one-to-one correspondence with the plurality of first heat-generating components (132), the plurality of flow-diverting structures (128) being configured to direct the coolant to flow along a direction along which the first heat-generating components (132) are arranged.

5. The power conversion system according to claim 4, wherein the plurality of flow-diverting structures (128) include a plurality of ribs (1281) spaced apart from each other, each of the plurality of ribs (1281) extending along a same direction as the plurality of first heat-generating components (132) are arranged, and the plurality of ribs (1281) being arranged in a direction perpendicular to the direction along which the plurality of first heat-generating components (132) are arranged.

6. The power conversion system according to claim 1, wherein a plurality of second heat-generating component (133) are provided, the plurality of second cooling rooms (123) are provided, and the plurality of second heat-generating components (133) are in one-to-one correspondence with the plurality of second cooling rooms (123).

7. The power conversion system according to claim 6, wherein a respective second cooling room of the plurality of second cooling rooms (123) is provided with a plurality of turbulence columns (129) arranged in an array inside the respective second cooling room.

8. The power conversion system according to claim 6, wherein the plurality of second cooling rooms (123) include a plurality of first compartments (1231) and a plurality of second compartments (1232) that are in one-to-one correspondence, and the plurality of first compartments (1231) each being spaced apart from and in fluid communication with the corresponding second compartment (1232).

9. The power conversion system according to claim 8, wherein at least some of the plurality of first compartments (1231) are in fluid communication with the first cooling room (122).

10. The power conversion system according to claim 1, wherein the flow channel (121) is provided with a partition (14), the partition (14) extends in a same direction as the flow channel (121), and the partition (14) is provided with a notch (141) facing the first cooling room (122) or the second cooling room (123).

11. The power conversion system according to claim 1, wherein the housing (11) includes a first inner wall surface facing one side surface of the liquid cooling plate (12) and a second inner wall surface facing the other side surface of the liquid cooling plate (12), the liquid cooling plate (12) being spaced apart from both the first and second inner wall surfaces, and the liquid cooling plate (12) being provided with a through hole (15) extending in a thickness direction of the liquid cooling plate (12).

12. The power conversion system according to claim 11, wherein a plurality of through holes (15) are provided, and the plurality of through holes (15) are distributed between the first cooling room (122) and the second cooling room (123).

13. The power conversion system according to claim 1, wherein the flow channel (121) includes an inlet flow channel (1213), an outlet flow channel (1214), and a series flow channel (1215), one end of the inlet flow channel (1213) being in fluid communication with the inlet pipeline (124), the other end of the inlet flow channel (1213) being in fluid communication with the first cooling room (122), one end of the outlet flow channel (1214) being in fluid communication with the outlet pipeline (125), the other end of the outlet flow channel (1214) being in fluid communication with the second cooling room (123), and the first cooling room (122) being in fluid communication with the second cooling room (123) through the series flow channel (1215);
optionally, wherein the inlet flow channel (1213) and the outlet flow channel (1214) are located on opposite sides of the first cooling room (122) or the second cooling room (123).

14. The power conversion system according to claim 1, wherein the liquid cooling plate (12) has a first edge and a second edge arranged opposite to each other, the first heat-generating component (132) is arranged along the first edge, and the inlet pipeline (124) and the outlet pipeline (125) are connected to the second edge.

15. The power conversion system according to claim 1, further comprising:
a liquid detection assembly (104) arranged in the receiving chamber (101) and adjacent to the inlet pipeline (124) or the outlet pipeline (125).
